Europäisches Patentamt

European Patent Office

Office européen des brevets

(11) Veröffentlichungsnummer: **0 140 353**
**B1**

(12) **EUROPÄISCHE PATENTSCHRIFT**

(45) Veröffentlichungstag der Patentschrift:
07.01.88

(51) Int. Cl.⁴: **G 03 C 1/68**

(21) Anmeldenummer: **84112929.9**

(22) Anmeldetag: **26.10.84**

(54) **Photopolymerisierbare Aufzeichnungsmaterialien zur Herstellung von Druckformen sowie Verfahren zur Herstellung von Druckformen mittels dieser Aufzeichnungsmaterialien.**

(30) Priorität: **03.11.83 DE 3339815**

(43) Veröffentlichungstag der Anmeldung:
**08.05.85 Patentblatt 85/19**

(45) Bekanntmachung des Hinweises auf die Patenterteilung:
**07.01.88 Patentblatt 88/1**

(84) Benannte Vertragsstaaten:
**DE FR GB IT NL**

(56) Entgegenhaltungen:
**EP - A - 0 076 028**
**FR - A - 2 350 625**
**GB - A - 835 849**

(73) Patentinhaber: **BASF Aktiengesellschaft,
Carl-Bosch-Strasse 38, D-6700 Ludwigshafen (DE)**

(72) Erfinder: **Hartmann, Heinrich, Dr., Weinheimer
Strasse 46, D-6703 Limburgerhof (DE)**
Erfinder: **Hoffmann, Gerhard, Dr., Mandelbergstrasse 44,
D-6730 Neustadt 23 (DE)**
Erfinder: **Buensch, Hellmut, Dr., Kreuzweg 17,
D-2000 Norderstedt (DE)**
Erfinder: **Hofmann, Reiner, Dr., Mandelbergstrasse 44,
D-6730 Neustadt 23 (DE)**

## Beschreibung

Die Erfindung betrifft photopolymerisierbare Aufzeichnungsmaterialien zur Herstellung von Druckformen, insbesondere Flachdruckformen, mit einer auf einem dimensionsstabilen Träger aufgebrachten wässrig-entwickelbaren, photopolymerisierbaren Kopierschicht (S). Die Erfindung betrifft des weiteren ein Verfahren zur Herstellung von Druckformen, insbesondere von Flachdruckformen, mittels dieser Aufzeichnungsmaterialien.

Mit Wasser oder wässrig-alkalischen Medien auswaschbare, photopolymerisierbare Aufzeichnungsmaterialien für die Herstellung von photopolymeren Druckformen, insbesondere Flachdruckplatten, sind bekannt. Diese enthalten auf einem dimensionsstabilen Träger, beispielsweise einer Kunststoff-Folie oder einem Metallblech, eine photopolymerisierbare Kopierschicht im allgemeinen aus einer Mischung von einem in Wasser oder wässrig-alkalischen Medien löslichen bzw. dispergierbaren polymeren Bindemittel, mindestens einem ethylenisch ungesättigten, photopolymerisierbaren Monomeren, mindestens einem Photoinitiator sowie gegebenenfalls weiteren Zusatz- und/oder Hilfsstoffen. Als polymere Bindemittel für die wässrig-entwickelbaren Kopierschichten sind dabei insbesondere carboxylgruppenhaltige oder Carbonsäureanhydrid-Gruppen enthaltende Polymere vorgeschlagen worden, wie z.B. (Meth)Acrylat-/(Meth)Acrylsäure-Copolymerisate, Styrol-Maleinsäureanhydrid-Copolymerisate oder Styrol-Maleinsäurehalbester-Copolymerisate (vgl. unter anderem DE-B-2 027 467, DE-B-2 064 080, DE-A-2 205 146 oder EP-A-49 504).

Die bekannten photopolymerisierbaren, wässrig-entwickelbaren Aufzeichnungsmaterialien für die Herstellung von Druckformen sind zwar für viele Zwecke brauchbar und geeignet, genügen jedoch noch nicht allen an diese Materialien gestellten Anforderungen. So sind insbesondere recht lange Belichtungszeiten erforderlich, um die im Offset-Druck als Standard geltenden feinen Bildelemente (z.B. Tonwerte unter 2% bei einem Raster von 60 L/cm) korrekt abzubilden und dauerhaft auf dem Schichtträger zu verankern. Häufig ist auch das Auflösungsvermögen dieser Aufzeichnungsmaterialien noch unbefriedigend. Ein weiterer Nachteil ist die Empfindlichkeit der photopolymerisierten Schichten gegenüber dem Auswaschmedium, d.h. die Überwaschempfindlichkeit ist gross. Dies verursacht während des Herstellungsprozesses der Druckklischees eine hohe Ausschussquote. Es besteht somit ein Bedarf an weiteren, verbesserten wässrig-entwickelbaren, photopolymerisierbaren Aufzeichnungsmaterialien für die Herstellung von Druckformen.

In der FR-A-2 350 625 werden lichtempfindliche Zusammensetzungen und Druckformen, die diese Zusammensetzungen enthalten, beschrieben. Diese Zusammensetzungen bestehen aus Gemischen von Copolymerisaten aus konjugierten Diolefinen, wie Butadien, Isopren, Chloro-pren oder Dimethylbutadien, α,β-ethylenisch ungesättigten Verbindungen, wie Styrol, (Meth)-acrylnitril u.a., einem photopolymerisierbaren Monomeren und einem Photoinitiator. Wie der Beschreibung und den Beispielen dieser Patentschrift zu entnehmen ist, sollen die Copolymerisate Molekulargewichte zwischen 1000 und 200 000, vorzugsweise 5000 bis 100 000 aufweisen (vgl. Seite 14, Zeilen 25 bis 27 dieser FR-A). Hier wird ausdrücklich darauf hingewiesen (vgl. Seite 14, Zeile 27 bis 37), dass derartige Copolymerisate mit Molekulargewichten unter 1000 flüssig sind. In den Beispielen dieser FR-A werden daher auch nur Molekulargewichte von 17 000 bis 35 000 genannt.

Aufgabe der vorliegenden Erfindung war es, neue photopolymerisierbare Aufzeichnungsmaterialien für die Reprographie, insbesondere für die Herstellung von Flachdruckplatten, bereitzustellen, die wässrig-entwickelbar sind und die ganz allgemein gute anwendungstechnische und drucktechnische Eigenschaften aufweisen. Insbesondere sollen die Aufzeichnungsmaterialien neben einer geringen Sauerstoffempfindlichkeit gleichzeitig eine hohe Lichtempfindlichkeit und ein sehr gutes Auflösungsvermögen besitzen, nach der Belichtung in wässrigen Medien, insbesondere wässrig-alkalischen Medien mit relativ niedrigen pH-Werten, entwickelt werden können, dennoch eine geringe Überwaschempfindlichkeit zeigen und eine hohe Wasserbeständigkeit, wie sie insbesondere im Offset-Druck gefordert wird, besitzen, und zu Druckformen verarbeitbar sein, die hohe Druckauflagen unbeschadet überstehen.

Es wurde nun gefunden, dass diese Aufgabe durch photopolymerisierbare Aufzeichnungsmaterialien mit einer auf einem Träger aufgebrachten photopolymerisierbaren Kopierschicht (S) gelöst wird, die neben niedermolekularen, photopolymerisierbaren Verbindungen, mindestens einem Photoinitiator sowie weiteren Zusatz- und gegebenenfalls Hilfsstoffen als Bindemittel mindestens ein oligomeres und/oder höhermolekulares, in wässrig-alkalischen Medien lösliches oder dispergierbares Copolymerisat auf der Basis von cyclischen Dienen enthält.

Gegenstand der Erfindung sind dementsprechend photopolymerisierbare Aufzeichnungsmaterialien zur Herstellung von Druckformen, insbesondere Flachdruckformen, mit einer auf einem dimensionsstabilen Träger aufgebrachten, photopolymerisierbaren, wässrig-entwickelbaren Kopierschicht (S) einer Mischung von

(a) einem in wässrig-alkalischen Medien löslichen oder dispergierbaren polymeren Bindemittel,

(b) mindestens einer ethylenisch ungesättigten, photopolymersierbaren, niedermolekularen Verbindung,

(c) mindestens einem Photopolymerisationsinitiator,

(d) mindestens einem Farbstoff und/oder einem Pigment sowie

(e) gegebenenfalls weiteren Zusatz- und/oder Hilfsstoffen,

2

wobei diese Aufzeichnungsmaterialien dadurch gekennzeichnet sind, dass in der photopolymerisierbaren Kopierschicht (S) als Bindemittel (a) mindestens ein oligomeres, in wässrig-alkalischen Medien lösliches oder dispergierbares Copolymerisat mit einem mittleren Molekulargewicht im Bereich von etwa 500 bis 1 000 auf Basis von cyclischen Dienen, insbesondere von gegebenenfalls substituiertem (Di-, Tri-)Cyclopentadien, und/oder ein durch Umsetzung derartiger oligomerer Copolymerisate mit einer unterstöchiometrischen Menge an mehrfunktionellen Verbindungen, die mit den Anhydrid – oder freien Carboxylgruppen der oligomeren Copolymerisate zu reagieren vermögen, erhaltenes höhermolekulares, in wässrig-alkalischen Medien lösliches oder dispergierbares Copolymerisat enthalten ist.

Gegenstand der Erfindung ist weiterhin ein Verfahren zur Herstellung von Druckformen, insbesondere Flachdruckformen, mittels eines photopolymerisierbaren Aufzeichnungsmaterials mit einer auf einem dimensionsstabilen Träger aufgebrachten photopolymeriserbaren Kopierschicht (S), bei dem die photopolymerisierbare Kopierschicht (S) bildmässig mit aktinischem Licht belichtet wird, die unbelichteten Anteile der Schicht (S) mit einem wässrigen Entwicklerlösungsmittel entfernt werden und die so erhaltene Druckform anschliessend gegebenenfalls getrocknet und nachgehärtet wird, welches dadurch gekennzeichnet ist, dass in diesem Verfahren ein erfindungsgemässes Aufzeichnungsmaterial der vorstehend beschriebenen Art eingesetzt wird.

Durch die erfindungsgemässe Verwendung von in wässrig-alkalischen Medien löslichen bzw. dispergierbaren Copolymerisaten auf Basis von cyclischen Dienen, insbesondere von freien Carboxylgruppen und/oder Carbonsäureanhydrid-Gruppen enthaltenden Copolymerisaten auf Basis cyclischer Diene, können nicht nur Druckformen mit sehr guten, vielfach verbesserten anwendungstechnischen und drucktechnischen Eigenschaften hergestellt werden, sondern je nach Art des als Bindemittel verwendeten Copolymerisats der cyclischen Diene und der Verfahrensführung lassen sich die Eigenschaften der Druckformen in vielfältiger und einfacher Weise variieren und dadurch dem gewünschten Verwendungszweck, insbesondere der zu erwartenden Beanspruchung, anpassen.

Die erfindungsgemässen Aufzeichnungsmaterialien enthalten in der wässrig-entwickelbaren, photopolymerisierbaren Kopierschicht (S) als Bindemittel (a) in wässrig-alkalischen Medien löslich bzw. dispergierbare Copolymerisate auf Basis cyclischer Diene, insbesondere des Cyclopentadien-Typs. Als Beispiele für Monomere des Cyclopentadien-Typs, die für den Aufbau der erfindungsgemäss als Bindemittel einzusetzenden Copolymerisate in Betracht kommen, seien genannt: Cyclopentadien, Dicyclopentadien, Tricyclopentadien, Tetracyclopentadien sowie deren Substitutionsprodukte, insbesondere deren alkylsubstituierte Derivate, die mindestens eine niedere Alkylgruppe mit 1 bis 3 Kohlenstoffen enthalten, wie z.B. Methyl-cyclopentadien, Methyl-dicyclopentadien oder Methyl-tricyclopentadien. Vorzugsweise geht man zur Herstellung der erfindungsgemäss einzusetzenden Copolymerisate von Cyclopentadien, Dicyclopentadien und/oder Methyl-dicyclopentadien aus, insbesondere aber von Dicyclopentadien.

Die erfindungsgemäss als Bindemittel (a) einzusetzenden Copolymerisate auf Basis der cyclischen Diene enthalten als weitere Co-Bausteine vorzugsweise Comonomere mit Carbonsäureanhydrid-Gruppen und/oder Comonomere mit freien Carboxylgruppen einpolymerisiert. Dies sind insbesondere $\alpha,\beta$-ungesättigte Dicarbonsäuren, vorzugsweise mit 4 bis 8 C-Atomen, deren Anhydride und/oder deren Halbester. Hierzu gehören unter anderem Maleinsäure, Fumarsäure, Itaconsäure, Mucochlorsäure oder Muconsäure und deren Derivate, insbesondere deren Anhydride und/oder Halbester. Besonders bevorzugt sind solche Copolymerisate, die neben den Monomeren des Cyclopentadien-Typs Maleinsäureanhydrid und/oder Maleinsäurehalbester als Co-Bausteine einpolymerisiert enthalten.

Neben den Monomeren des Cyclopentadien-Typs und den genannten Carbonsäure- oder Carbonsäureanhydrid-Gruppen enthaltenden Comonomeren können die erfindungsgemäss als Bindemittel einzusetzenden Copolymerisate weitere Comonomere einpolymerisiert enthalten. Hierzu gehören insbesondere Vinylaromaten, wie z.B. Styrol, substituierte Styrole, die in der Seitenkette oder im Kern beispielsweise durch Alkylgruppen oder Halogenatome substituiert sind, wie $\alpha$-Methylstyrol, o- oder p-Chlorstyrol, Stilben und ähnliche. Im allgemeinen enthalten die erfindungsgemäss als Bindemittel (a) einzusetzenden Copolymerisate 95 bis 45 Gew.-%, mindestens eines Monomeren vom Cyclopentadien-Typs, 5 bis 45 Gew.-%, mindestens einer ungesättigten Dicarbonsäure und/oder deren Derivate, insbesondere des Anhydrides einer $\alpha,\beta$-ungesättigten Dicarbonsäure, sowie 0 bis 30 Gew.-% an weiteren Comonomer-Bausteinen einpolymerisiert bzw. eingebaut. Diese Copolymerisate können in der photopolymerisierbaren Kopierschicht (S) – je nach angestrebtem Eigenschaftsbild der erfindungsgemässen Aufzeichnungsmaterialien bzw. der hieraus hergestellten Druckformen – allein oder in Mischung miteinander und sowohl in unmodifizierter als auch in modifizierter Form eingesetzt werden. Ihr mittleres Molekulargewicht liegt, in Abhängigkeit vom jeweiligen Typ des Copolymerisats, im allgemeinen über etwa 500.

Gemäss einer Ausführungsform der Erfindung enthält die photopolymerisierbare Kopierschicht (S) als Bindemittel (a) ein oligomeres Copolymerisat aus einem überwiegenden Anteil mindestens eines Cyclopentadien-Monomeren, dem Anhydrid einer $\alpha,\beta$-ungesättigten Dicarbonsäure, vorzugsweise Maleinsäureanhydrid, sowie gegebenenfalls weiteren Comonomeren, wie z.B. Vinylaromaten. Unter Cyclopentadien-Monomeren sind hier, sowie im folgenden, die Monomeren des Cyclopentadien-Typs der oben genannten Art zu verstehen, wobei Dicyclopentadien insbesondere bevorzugt ist. Besonders vorteilhafte Copolymerisate dieses Typs bestehen aus 55 bis 95 Gew.-%, insbesondere 56 bis 75 Gew.-%, mindestens eines Cyclopentadien-Monomeren sowie 5 bis 45 Gew.-%, insbesondere 25 bis 44 Gew.-%, des Anhydrids einer α,β-ungesättigten Dicarbonsäure, insbesondere Maleinsäureanhydrid. Das mittlere Molekulargewicht dieser oligomeren Copolymerisate liegt im Bereich zwischen etwa 500 bis 1000. Diese oligomeren Copolymerisate können nach bekannten Verfahren durch gemeinsames Erhitzen der Comonomeren auf Temperaturen um oder über 250 °C, gegebenenfalls in Anwesenheit von radikalischen Katalysatoren, hergestellt werden. Bei diesen oligomeren Copolymerisaten handelt es sich um braune, in vielen Lösungsmitteln gut lösliche und daher gur verarbeitbare Produkte, deren Erweichungsbereich üblicherweise zwischen 170 °C und 280 °C liegt. Es war ganz besonders überraschend, dass Druckplatten, die in der Kopierschicht solche oligomeren Bindemittel enthalten, die hohen Anforderungen, die an diese Platten insbesondere im Offset-Druck gestellt werden, erfüllen können.

In einer anderen, ebenfalls sehr vorteilhaften Ausführungsform der Erfindung sind in der photopolymerisierbaren Kopierschicht (S) als Bindemittel (a) oligomere Copolymerisate aus einem überwiegenden Anteil mindestens eines Cyclopentadien-Monomeren enthalten, die als Comonomer-Bausteine Halbester von α,β-ungesättigten Dicarbonsäuren, insbesondere Maleinsäurehalbester, eingebaut enthalten. Man erhält diese oligomeren Copolymerisate in einfacher Weise dadurch, dass man in den vorstehend beschriebenen Copolymerisaten aus Cyclopentadien-Monomeren und α,β-ungesättigten Dicarbonsäureanhydriden, insbesondere Maleinsäurehydrid, die Anhydridgruppen mit entsprechenden Alkoholen, insbesondere Alkanolen mit 1 bis 8 C-Atomen, teilverestert. Von besonderem Interesse sind hierbei unter anderem die oligomeren Copolymerisate, die neben einem überwiegenden Anteil an Cyclopentadien-Monomeren sowohl Maleinsäureanhydrid-Gruppen als auch Maleinsäurehalbester-Gruppen als Comonomer-Bausteine eingebaut enthalten. Als Beispiele hierfür seien solche oligomeren Copolymerisate, insbesondere mit einem mittleren Molekulargewicht im Bereich von etwa 500 bis 1000, genannt, die aus 55 bis 95 Gew.-%, insbesondere 60 bis 80 Gew.-%, an Cyclopentadien-Monomeren, 0 bis 30 Gew.-%, insbesondere 5 bis 30 Gew.-%, an Maleinsäureanhydrid-Gruppen und 5 bis 45 Gew.-%, insbesondere 5 bis 30 Gew.-%, an Maleinsäurehalbester-Gruppen aufgebaut sind.

In einer speziellen Ausgestaltung dieser Ausführungsform der Erfindung werden als Bindemittel (a) solche Copolymerisate aus Cyclopentadien-Monomeren und Anhydriden α,β-ungesättigter Dicarbonsäuren eingesetzt, deren Anhydridgruppen ganz oder teilweise, vorzugsweise bis zu etwa 60%, mit Hydroxylgruppen-haltigen Verbindungen halbverestert sind, die photopolymerisierbare ethylenische Doppelbindungen enthalten. Sehr günstig sind dabei solche Copolymerisate, deren Anhydrid-Gruppen mit hydroxylgruppenhaltigen Acrylaten und/oder Methacrylaten, insbesondere Hydroxyalkyl-(meth)acrylaten, halbverestert sind, wie z.B. mit 2-Hydroxyethyl-(meth)acrylat, 2-Hydrocypropyl-(meth)acrylat, 3-Hydroxypropyl-(meth)acrylat, Butandiol-1,4-mono-(meth)acrylat, den Mono-(meth)acrylaten von Diethylenglykol, Triethylenglykol oder Tetraethylenglykol, und ähnlichen. Besonders günstige Ergebnisse haben dabei solche oligomeren Copolymerisate aus 60 bis 80 Gew.-% mindestens eines Cyclopentadien-Monomeren und 20 bis 40 Gew.-% Maleinsäureanhydrid ergeben, deren Maleinsäureanhydrid-Gruppen bis zu 60%, insbesondere zu 20 bis 60%, mit Hydroxyalkyl-(meth)acrylaten der genannten Art, insbesondere 2-Hydroxyethyl-(meth)acrylat und den Hydroxypropyl-(meth)acrylaten, halbverestert waren. Diese Copolymerisate, deren mittleres Molekulargewicht gleichfalls im Bereich von etwa 500 bis 1000 liegt, sind ebenfalls braun gefärbt, leicht löslich und haben einen Erweichungsbereich im allgemeinen unter 200 °C. Durch die Einführung der photopolymerisierbaren Doppelbindungen in das Copolymerisat kann der Vernetzungs- und Härtungsgrad bei der Belichtung der Aufzeichnungsmaterialien erhöht bzw. der Anteil an niedermolekularen photopolymerisierbaren Verbindungen (b) reduziert werden.

Gemäss einer anderen Ausführungsform der Erfindung können als Bindemittel (a) in den photopolymerisierbaren Kopierschichten (S) auch modifizierte Copolymerisate aus Cyclopentadien-Monomeren, Anhydriden α,β-ungesättigter Dicarbonsäuren und/oder Halbestern α,β-ungesättigter Dicarbonsäuren, wie sie vorstehend beschrieben worden sind, zum Einsatz gelangen. Solche modifizierten Produkte erhält man beispielsweise durch Umsetzung der vorstehend genannten oligomeren Copolymerisate aus den Cyclopentadien-Monomeren, dem Anhydrid einer α,β-ungesättigten Dicarbonsäure, insbesondere Maleinsäureanhydrid, und/oder dem Halbester einer α,β-ungesättigten Dicarbonsäure, insbesondere Maleinsäurehalbester, mit mehrfunktionellen Verbindungen, die mit den Anhydrid- oder freien Carbonsäure-Gruppen zu reagieren vermögen. Als solche mehrfunktionellen Verbindungen für die Modifizierung der Copolymerisate kommen beispielsweise bis oder trifunktionelle Alkohole, bi- oder trifunktionelle Amine und ähnliche in Betracht.

Gemäss dieser erfindungsgemässen Ausführungsform werden als Bindemittel (a) für die photopolymerisierbare Kopierschicht (S) solche Polymeren herangezogen, die durch Umsetzung der vorstehend beschriebenen oligomeren Copolymerisate aus Cyclopentadien-Monomeren, Anhydriden von α,β-umgesättigten Dicarbonsäuren und/oder Halbestern von α,β-ungesättigten Dicarbonsäuren mit einer unterstöchiometrischen Menge an mehrfunktionellen Verbindungen, die mit den Anhydrid- oder freien Carboxyl-Gruppen der oligomeren Copolymerisate zu reagieren vermögen, erhalten worden sind. Man erhält dadurch auf einfache Weise höhermolekulare, carbonsäuremodifizierte Copolymerisate auf Basis von Cyclopentadien-Monomeren mit mittleren Molekulargewichten beispielsweise auch über 1000. Solche höhermolekularen, kettenverlängerten Copolymerisate der in Rede stehenden Art lassen sich durch Umsetzung der oligomeren Copolymerisate mit den mehrfunktionellen Verbindungen in einem indifferenten Lösungsmittel bei höheren Temperaturen leicht herstellen. Als mehrfunktionelle Verbindungen kommen dabei insbesondere bi- oder trifunktionelle Alkohole, bi- oder trifunktionelle Amine und dergleichen in Betracht. Die mehrfunktionellen Verbindungen für die Kettenverlängerung können dabei auch noch weitere funktionelle Gruppen, z.B. ethylenisch ungesättigte, photopolymerisierbare Reste tragen. Als Beispiele für mehrfunktionelle Verbindungen, die für die Modifizierung und Kettenverlängerung der oligomeren Copolymerisate geeignet sind, seien genannt: Monoethylenglykol, Diethylenglykol, Triethylenglykol, Tetraethylenglykol, Polyethylenglykole, insbesondere mit Molekulargewichten bis ca. 500; 1,2-Propylenglykol, 1,3-Propylenglykol, Polypropylenglykole, insbesondere mit einem Molekulargewicht bis etwa 500; Butandiol, Hexandiol, Glycerin, Neopentylglykol, Pentaerythrit, Trimethylolpropan; Pentaerythrit-mono-(meth)acrylat, Pentaerythrit-di-(meth)acrylat, Trimethylolpropan-mono-(meth)-acrylat, Butendiol-1,4; Ethylendiamin, Propylendiamin, 4,4'-Diaminodiphenylmethan, 4,4'-(N,N'-Dimethyl)-diaminodiphenylmethan; Aminoalkanole, wie 2-Hydroxyethylamin und ähnliche.

Neben den Bindemitteln (a) der genannten Art enthält die photopolymerisierbare Kopierschicht (S) mindestens eine ethylenisch ungesättigte, photopolymerisierbare, niedermolekulare Verbindung (b). Als solche kommen prinzipiell alle für photopolymerisierbare Mischungen und Schichten bekannten niedermolekularen photopolymerisierbaren Verbindungen, insbesondere die ethylenisch ungesättigten, photopolymerisierbaren Monomeren und Oligomeren (mit einem Molekulargewicht bis etwa 5000, insbesondere mit einem Molekulargewicht bis etwa 3000) in Betracht. Die ethylenisch ungesättigten, photopolymerisierbaren, niedermolekularen Verbindungen (b) können mono- oder auch mehrfunktionell sein, d.h. eine oder mehrere ethylenische, photopolymerisierbare Doppelbindungen besitzen. Üblicherweise sind in der photopolymerisierbaren Kopierschicht (S) als Komponente (b) bi- oder mehrfunktionelle ethylenisch ungesättigte, photopolymerisierbare, niedermolekulare Verbindungen allein oder Mischungen hiervon mit monofunktionellen ethylenisch ungesättigten, photopolymerisierbaren, niedermolekularen Verbindungen enthalten. Es ist aber grundsätzlich auch möglich, dass die photopolymerisierbare Kopierschicht (S) nur monofunktionelle ethylenisch ungesättigte, photopolymerisierbare, niedermolekulare Verbindungen enthält, insbesondere dann, wenn die als Bindemittel (a) eingesetzten Copolymerisate auch bereits schon Gruppen mit photopolymerisierbaren, ethylenischen Doppelbindungen eingebaut enthalten.

Als ethylenisch ungesättigte, photopolymerisierbare, niedermolekulare Verbindungen (b), die allein oder in Mischung miteinander eingesetzt werden können, eignen sich neben Allyl- und Vinyl-Verbindungen insbesondere (Meth)acrylsäure und deren Derivate und ganz besonders die (Meth)acrylsäureester. Beispiele für geeignete ethylenisch ungesättigte, photopolymerisierbare niedermolekulare Verbindungen (b) sind die Di- und Tri-(meth)acrylate von Ethylenglykol, Diethylenglykol, Triethylenglykol oder Polyethylenglykolen mit einem Molekulargewicht bis etwa 500, 1,2-Propandiol, 1,3-Propandiol, 1,4-Butandiol, 1,1,1-Trimethylolpropan, Neopentylglykol, (2,2-Dimethylpropandiol), Glycerin oder Pentaerythrit; Glukosetri- oder -tetra-(meth)acrylat; ferner die Monoacrylate und Monomethacrylate der genannten Diole und Polyole, wie z.B. Ethylenglykol-, Di-, Tri- oder Tetraethylenglykolmono(meth)acrylat und die (Meth)acrylate von Monoalkanolen, insbesondere mit 1 bis 20 C-Atomen; weiterhin Monomere mit 2 oder mehr ethylenisch ungesättigten Bindungen, die Urethangruppen und/oder Amidgruppen enthalten, wie z.B. die aus aliphatischen Diolen der vorstehend genannten Art, organischen Diisocyanaten und Hydroxyalkyl-(meth)acrylaten hergestellten niedermolekularen Urethan-(meth)acrylate. Genannt seien auch Verbindungen wie z.B. Divinylethylen- oder -propylenharnstoff, N-Vinylpyrrolidon, N-Vinylcaprolactam, Vinylacetat oder -propionat, N-Methylol-(meth)acrylamid, der Bisether des Ethylenglykols und N-Methylol-(meth)acrylamids, Vinylcarbamate, N-(p-Diphenylamin)acrylamid, Vinylmethylacetamid, Bisacrylamidoessigsäure, Glyoxalbisacrylamid und andere. Die ethylenisch ungesättigten, photopolymerisierbaren, niedermolekularen Verbindungen (b) werden dabei — für den Fachmann selbstverständlich — so gewählt, dass sie mit den eingesetzten Bindemitteln (a) verträglich sind.

Ferner enthalten die photopolymerisierbaren Kopierschichten (S) der erfindungsgemässen Aufzeichnungsmaterialien mindestens einen Photopolymerisationsinitiator. Als solche kommen die für photopolymerisierbare Aufzeichnungsmaterialien, insbesondere für die Herstellung von Offset-Druckplatten oder Resistschichten, bekannten Photoinitiatoren bzw. Photoinitiatorsysteme in Betracht. Als Beispiele für geeignete Photoinitiatoren seien neben Verbindungen wie Benzoin, den Benzoinderivaten, wie Benzoinethern, den substituierten Benzoinen, substituierten Benzoinderivaten z.B. substituierten Benzoinethern, den Benzilen, insbesondere Benzilketalen, oder den Acylphosphinoxid-Verbindungen insbesondere Verbindungen vom Typ des Benzophenons und seiner Derivate, wie Benzophenon, 4,4'-Dimethylaminobenzophenon, 4,4'-Diethylaminobenzophenon, Derivate von Michlers Keton, 4,4'-Dichlorbenzophenon etc. und deren Gemische; Anthrachinone, wie 2-Ethylanthrachinon, t-Butylanthrachinon etc.; Bisimidazolderivate, wie 2,4,5-Triarylimidazoldimere; 2-Chlorthioxanthon, und die als Photoinitiatoren wirksamen Acridin- oder Phenazin-Derivate genannt. Beispiele für Initiatorsysteme sind Kombinationen der genannten Initiatoren mit Sensibilisierungshilfsmitteln, wie insbesondere tertiären Aminen. Typische Beispiele für solche Initiatorsysteme sind Kombinationen aus Benzophenon oder Benzophenonderivaten mit tertiären Aminen, wie Triethanolamin oder Michlers Keton; oder Gemische aus 2,4,5-Triarylimidazoldimeren und 2-Mercaptobenzochinazol, Leucokristallviolett, Tris-(4-diethylamino-2-methylphenyl)-methan und ähnlichen. Die Photoinitiatoren und Photoinitiator-Systeme sind in der einschlägigen Literatur hinreichend beschrieben, und ihre Auswahl ist dem Fachmann geläufig.

Die photopolymerisierbare Kopierschicht (S) der erfindungsgemässen Aufzeichnungsmaterialien enthält als weitere Komponente (d) Farbstoffe und/oder Pigmente. Diese können sowohl als Kontrastmittel als auch schichtverfestigend wirken. In Frage kommen beispielsweise solche Farbstoffe, wie sie in den US-PSs 3 218 167 und 3 884 693 beschrieben sind. Besonders geeignet sind z.B. Viktoria-Reinblau FGA, Viktoria-Reinblau BO (C.I. 42 595), Malchitgrün, Kristallviolett, Viktoria-Blau B (C.I. 44 045), Rhodamin 6 GDN (C.I. 45 160), Fettrot 5 B (C.I. 26 125), Neozaponblau FLE (C.I. Solvent Blue 70), Brillantblausalz-Acetat, Samaron-marineblau, Orasolblau GN, Renolblau B2G (C.I. 74 160), Zaponecht-Feuerrot B (C.I. 13 900:1). Zur Erhöhung des Bildkontrastes nach dem Belichten können beispielsweise Farbstoffe wie Metanilgelb (C.I. 13 065), Methylorange (C.I. 13 025) oder Phenylazodiphenylamin verwendet werden.

Oft ist es von Vorteil, wenn die photopolymerisierbare Kopierschicht (S) der erfindungsgemässen Aufzeichnungsmaterialien zusätzlich weitere Zusatz- und/oder Hilfsstoffe (e) zur Verbesserung und/oder Modifizierung der allgemeinen Eigenschaften der Aufzeichnungsmaterialien bzw. der hieraus hergestellten Druckformen enthält. Hierzu gehören insbesondere thermische Polymerisationsinhibitoren, wie z.B. Hydrochinon, Hydrochinon-Derivate, 2,6-Di-tert.-butyl-p-kresol, Nitrophenole, N-Nitrosoamine, wie N-Nitrosodiphenylamin oder die Salze, insbesondere die Alkali- oder Aluminiumsalze, des N-Nitrosocyclohexylhydroxylamins. Ferner können in der Kopierschicht (S) sensitometrische Regler enthalten sein, wie sie an sich bekannt und in der Literatur beschrieben sind. Hierzu gehören beispielsweise 9-Nitroanthracen, 10,10'-Bisanthrone, Phenazinium-, Phenoxazinium-, Acridinium- oder Phenotiazinium-Farbstoffe, 1,3-Dinitrobenzole und ähnliche. Als Zusatz- und/oder Hilfsstoffe kommen z.B. auch Füllstoffe, Verstärkungsmittel oder weitere, die mechanischen Eigenschaften verbessernde Bindemittel in Betracht, wobei die letztgenannten mit den anderen Komponenten der photopolymerisierbaren Kopierschicht (S) verträglich sein sollen.

In einer besonderen Ausgestaltungsform der Erfindung können die photopolymerisierbaren Kopierschichten (S) als Zusatzstoffe auch solche Verbindungen enthalten, die mit den Anhydrid- oder Carbonsäure-Gruppen des als Bindemittel (a) enthaltenen Copolymerisates unter dem Einfluss von Wärme und/oder Licht Vernetzungsreaktionen einzugehen vermögen. Solche unter dem Einfluss von Wärme und/oder Licht vernetzend wirkenden Verbindungen sind beispielsweise Di- oder Polyepoxide sowie verkappte Di- oder Polyisocyanate. Als Di- oder Polyepoxide kommen dabei beispielsweise die Umsetzungsprodukte von Epichlorhydrin mit Polyolen, die Umsetzungsprodukte von Epichlorhydrin mit Polyaminen, Polyolefinepoxide, epoxidiertes Polybutadien, Epoxiharze vom Novolak-Typ, Glycidylester ungesättigter Carbonsäuren, insbesondere der (Meth)acrylsäure, und andere in Betracht. Als Beispiele für verkappte Di- oder Polyisocyanate seien genannt: das Umsetzungsprodukt aus 1 Mol Trimethylolpropan, 3 Mol 2,4-Diisocyanatotoluol und 3 Mol Phenol; das Isocyanuratderivat, welches durch Trimerisierung des Umsetzungsproduktes von 2,4-Diisocyanatotoluol und Kresol erhalten wird; sowie die aus Toluylendiisocyanat, Trimethylolpropan, Butandiol und Kresol hergestellten verkappten Isocyanate. Durch den Zusatz dieser vernetzend wirkenden Verbindungen kann nach der eigentlichen Herstellung der Druckform eine zusätzliche Vernetzung und Härtung in der bildmässig belichteten und entwickelten Kopierschicht (S) erreicht und dadurch die Eigenschaften, insbesondere die Beständigkeit, der Druckformen variiert und modifiziert werden. Um eine gute Lagerstabilität der Aufzeichnungsmaterialien zu gewährleisten, werden vorteilhaft solche vernetzend wirkenden Verbindungen eingesetzt, die erst bei erhöhten Temperaturen, beispielsweise über 60 °C, vorzugsweise über 80 °C, eine Vernetzungsreaktion mit den reaktiven Gruppen der Copolymerisate (a) eingehen. Es kann dabei von Vorteil sein, wenn zur Beschleunigung dieser Vernetzungsreaktion zusätzlich licht- und/oder wärme-aktivierbare Katalysatoren in der photopolymerisierbaren Kopierschicht (S) enthalten sind. Beispiele für solche thermisch und/oder photochemisch aktivierbaren Katalysatoren sind unter anderem Diazoniumsalze, Oniumsalze von Elementen der V., VI. und VII. Hauptgruppe des Periodensystems, Sulfoxoniumsalze oder auch Pyrriliumsalze (vgl. z.B. US-PS 3 205 157, US-PS 3 708 296, DE-A-2 518 656, DE-A-2 518 652, DE-A-2 904 626, EP-A-22 081, EP-A-35 696 und EP-A-74 073).

Die photopolymerisierbare Kopierschicht (S) der erfindungsgemässen Aufzeichnungsmaterialien enthält im allgemeinen, jeweils bezogen auf das Trockengewicht der gesamten Kopierschicht (S),

a) 40 bis 90 Gew.-% eines oligomeren und/ oder höhermolekularen Bindemittels gemäss Anspruch 1,

b) 8 bis 55 Gew.-% mindestens einer ethylenisch ungesättigten, photopolymerisierbaren niedermolekularen Verbindung der genannten Art,

c) 0,3 bis 12 Gew.-% mindestens eines Photopolymerisationsinitiators,

d) 0,005 bis 0,5 Gew.-% mindestens eines Farbstoffes und/oder Pigmentes sowie

e) 0 bis 20 Gew.-% an weiteren, die allgemeinen Eigenschaften der Aufzeichnungsmaterialien bzw. der hieraus hergestellten Druckformen verbessernden bzw. modifizierenden Zusatz- und/ oder Hilfsstoffen.

Als dimensionsstabiler Träger für die photopolymerisierbare Kopierschicht (S) kommen die als Schichtträger an sich bekannten und üblichen dimensionsstabilen, starren oder vorzugsweise flexiblen Schichtträger, beispielsweise aus Kunststoff-Folien, wie z.B. Polyesterfolien, oder aus Metallen in Betracht. Besonders vorteilhaft sind dabei die metallischen Schichtträger, z.B. aus Magnesium, Zink, Kupfer, mechanisch, chemisch und/oder elektrochemisch aufgerauhtem Aluminium, anodisiertem Aluminium, Stahl etc. Für die Herstellung von Flachdruckformen werden als Schichtträger insbesondere Aluminiumbleche bevorzugt, die für diesen Zweck in üblicher Weise vorbehandelt sind, z.B. durch mechanisches, chemisches oder elektrochemisches Aufrauhen und gegebenenfalls anschliessende anodische Oxidation. Eine weitere Behandlung dieses Trägermaterials, z.B. mit Polyvinylphosphonsäure, Alkalisilikaten, Phosphaten, Hexafluorzirkonaten, Chromaten, Boraten, Polyacrylamiden oder Cellulosederivaten ist vorteilhaft.

Die Herstellung der erfindungsgemässen photopolymerisierbaren Aufzeichnungsmaterialien kann in an sich bekannter und üblicher Weise erfolgen, beispielsweise indem man die Komponenten der photopolymerisierbaren Kopierschicht (S) in einem geeigneten Lösungsmittel oder Lösungsmittelgemisch löst und diese Lösung durch Giessen, Tauchen, Sprühen oder andere bekannte Auftragstechniken in der gewünschten Schichtstärke auf den Träger aufbringt. Anschliessend wird das Lösungsmittel in üblicher Weise entfernt und die photopolymerisierbare Kopierschicht (S) getrocknet. Geeignete Lösungsmittel für die Herstellung der photopolymerisierbaren Kopierschicht (S) sind unter anderem Tetrahydrofuran, Dioxan, Dimethoxyethan, Diglykoldimethylether, Methylglykol, Ethylglykol, Diacetonalkohol, Methylisobutylketon, Methylglykolacetat und andere. Die Trockenschichtdicke der photopolymerisierbaren Kopierschicht (S) liegt je nach Verwendungszweck im allgemeinen zwischen 0,5 und 75 µm, vorzugsweise im Bereich von 0,8 bis 6 µm. Für die Herstellung von Flachdruckplatten beträgt die Trockenschichtdicke der photopolymerisierbaren Kopierschicht (S) üblicherweise etwa 0,5 bis 12 µm, vorzugsweise etwa 0,8 bis 2,5 µm.

Die photopolymerisierbare Kopierschicht (S) der erfindungsgemässen Aufzeichnungsmaterialien kann vorteilhafterweise mit einer weiteren, insbesondere etwa 2 bis 6 µm dicken Deckschicht versehen sein. Diese Deckschicht, die vor allem dem Schutz der photopolymerisierbaren Kopierschicht (S) bei der Lagerung und Handhabung der photopolymerisierbaren Aufzeichnungsmaterialien dient, ist entweder von der photopolymerisierbaren Kopierschicht (S) abziehbar oder vorteilhafterweise transparent und in dem gleichen Lösungsmittel löslich, wie es für die Entwicklung der bildmässig belichteten Kopierschicht (S) zur Anwendung kommt. Als besonders geeignet haben sich Deckschichten aus Polyvinylalkoholen oder Polyvinylalkohol-Derivaten erwiesen.

Die Herstellung von Druckformen, insbesondere von Flachdruckformen, aus den erfindungsgemässen photopolymerisierbaren Aufzeichnungsmaterialien kann nach den an sich bekannten und üblichen Verfahren erfolgen. Hierzu wird die photopolymerisierbare Kopierschicht (S) zunächst bildmässig mit aktinischem Licht belichtet. Die bildmässige Belichtung kann dabei mit diffusem Licht durch eine photographische Bildvorlage hindurch, beispielsweise durch ein photographisches Negativ oder Positiv, oder aber auch mit einem bildmässig modulierten Lichtstrahl, beispielsweise einem bildmässig modulierten Laserstrahl erfolgen. Für die bildmässige Belichtung der photopolymerisierbaren Kopierschicht (S) eignen sich die üblichen Lichtquellen von aktinischem Licht, wie beispielsweise UV-Fluoreszenz-Röhren, Quecksilberhoch-, -mittel- oder -niederdruckstrahler, superaktinische Leuchtstoffröhren, Xenon-Impulslampen, metallhalogenid-dotierte Lampen, Kohlebogenlampen ect., aber auch UV-Laser, Argonlaser und ähnliche. Die von den Lichtquellen emittierte Wellenlänge soll im allgemeinen zwischen 230 und 450 nm, bevorzugt zwischen 300 und 420 nm, liegen und insbesondere auf die Eigenabsorption des mitverwendeten Photoinitiators abgestimmt sein.

Durch die bildmässige Belichtung mit aktinischem Licht wird in den belichteten Bereichen der Kopierschicht (S) eine Photopolymerisation ausgelöst, die zu einer Vernetzung und damit Löslichkeitsdifferenzierung zwischen den belichteten und unbelichteten Schichtbereichen führt. Nach der bildmässigen Belichtung wird die Druckform durch Auswaschen der unbelichteten, unvernetzten Schichtbereiche mit einem wässrig-alkalischen Entwicklerlösungsmittel entwickelt. Das Entwickeln der Druckform kann durch Sprühen, Waschen, Bürsten ext. mit dem Entwicklerlösungsmittel erfolgen. Wegen der grossen Wasserbeständigkeit der belichteten Schichtbereiche der Kopierschicht (S) können die Auswaschbedingungen im Vergleich zu bekannten Aufzeichnungsmaterialien dieser Art verschärft werden, ohne dass dies zu einer Beeinträchtigung der hergestellten Druckform führt. Als Entwicklerlösungen für die erfindungsgemässen Aufzeichnungsmaterialien kommen insbesondere wässrig-alkalische Lösungen mit einem pH-Wert im Bereich von 8 bis 14, vorzugsweise im Bereich von 9 bis 12, in Betracht, die Puffersalze, z.B. wasserlösliche Alkaliphosphate, -silikate, -borate, -carbonate, -acetate oder -benzoate, enthalten. Als weitere Bestandteile der Entwicklerlösungsmittel können Netzmittel, vorzugsweise anionische Netzmittel, und gegebenenfalls wasserlösliche Polymere mitverwendet werden. Obwohl die erfindungsgemässen Aufzeichnungsmaterialien im allgemeinen mit rein wässrigen Entwicklerlösungen ausgewaschen werden, kann es in bestimmten Fällen zweckmässig sein, kleine Mengen eines organischen Lösungsmittels, welches mit der wässrigen Entwicklerlösung mischbar ist, zuzusetzen.

Nach dem Auswaschen werden die resultierenden Druckformen in üblicher Weise, gegebenenfalls bei Temperaturen bis zu 120 °C, getrocknet. In manchen Fällen ist es zweckmässig, die erhaltenen Druckformen anschliessend nochmals vollflächig mit aktinischem Licht nachzubelichten, um ihre Festigkeit zu erhöhen. Bei der Ausführungsform der erfindungsgemässen Aufzeichnungsmaterialien, gemäss der in der photopolymerisierbaren Kopierschicht (S) solche Verbindungen als Zusatzstoffe mitenthalten sind, die unter dem Einfluss von Wärme und/oder Licht mit den funktionellen Gruppen des Copolymerisats (a) eine Vernetzungsreaktion einzugehen vermögen, kann sich nach der Druckformherstellung noch ein Nachhärtungs- und Vernetzungsschritt anschliessen. Diese Nachvernetzung und Härtung kann – in Abhängigkeit von der Art der verwendeten Vernetzungsmittel und der gegebenenfalls mitverwendeten aktivierbaren Katalysatoren für diese Vernetzungsreaktion – entweder durch Belichtung mit aktinischem Licht induziert oder aber durch Erhitzen der Druckform im allgemeinen auf Temperaturen über 60 °C, insbesondere aber auf Temperaturen im Bereich von 80 bis etwa 220 °C, vorgenommen werden. Das Erhitzen der Druckformen kann dabei beispielsweise durch Beaufschlagen der Kopierschicht (S) mit Warmluft, beispielsweise in einem Ofen, oder durch Bestrahlung mit Wärmestrahlung, beispielsweise mittels eines IR-Strahlers, erfolgen. Über die Höhe der Erhitzungstemperatur sowie insbesondere auch über die Dauer der Erwärmung können dabei die Härte, Festigkeit sowie andere Eigenschaften der Druckform variiert und entsprechend dem jeweiligen Anwendungszweck im gewünschten Masse eingestellt werden.

Die erfindungsgemässen Aufzeichnungsmaterialien zeichnen sich durch vorteilhafte und ausgewogene Eigenschaften aus, besitzen insbesondere ein gutes Belichtungsverhalten, d.h. man kann mit vergleichsweise kurzen Belichtungszeiten arbeiten und erhält eine sehr hohe Auflösung. Auch feine Bildelemente werden korrekt wiedergegeben und besitzen die für den Druck notwendige Festigkeit. Die Aufzeichnungsmaterialien besitzen im Vergleich zu bekannten Aufzeichnungsmaterialien dieser Art, die beispielsweise als Bindemittel in der photopolymerisierbaren Schicht Styrol/Maleinsäureanhydrid-Copolymerisate enthalten, eine erheblich geringere Empfindlichkeit gegenüber Sauerstoff, was die Handhabung und Verarbeitung erleichtert. Trotz der Auswaschbarkeit der bildmässig belichteten Aufzeichnungsmaterialien mit wässrigen Entwicklerlösungsmitteln besitzen die belichteten Bereiche der Aufzeichnungsmaterialien eine hohe Wasserbeständigkeit. Die Gefahr des Überwaschens bei der Entwicklung der Druckformen ist im Vergleich zu den aus dem Stand der Technik bekannten Produkten deutlich reduziert. Die mit den erfindungsgemässen Aufzeichnungsmaterialien hergestellten Druckformen, insbesondere Flachdruckformen, besitzen gute mechanische und chemische Festigkeit und ermöglichen bei exakter Druckwiedergabe hohe Druckauflagen.

Die Erfindung wird durch die nachfolgenden Beispiele näher erläutert. Die in den Beispielen genannten Teile und Prozente beziehen sich, soweit nicht anders angegeben, auf das Gewicht.

Beispiel 1

Es wurde ein Oligomeres aus 75% Dicyclopentadin und 25% Maleinsäureanhydrid hergestellt, welches ein mittleres Molekulargewicht von etwa 820 und einen K-Wert von 9,8 besass. Eine Lösung aus 58 Teilen dieses Oligomeren, 33 Teilen Trimethylolpropandiacrylat, 6 Teilen Benzophenon, 2 Teilen Michlers Keton und 1 Teil Viktoriareinblau in 900 Teilen Tetrahydrofuran wurden so auf ein elektrochemisch aufgerauhtes und anodisch oxidiertes Aluminiumblech für Offsetplatten aufgebracht, dass nach dem Verdampfen des Lösungsmittels und Trocknen der Schicht (15 mind bei 70 °C) eine Trockenschichtdecke von 1,6 µm resultierte.

Das so hergestellte Aufzeichnungsmaterial wurde in einem offsettypischen Belichter mit einer 5 kW-starken Lampe bildmässig mit aktinischem Licht belichtet und anschliessend mit einer wässrig-alkalischen Lösung mit einem pH-Wert von 11,2 ausgewaschen. Es resultierte eine Offsetdruckplatte, die eine Auflagenhöhe von 25 000 Drucken ohne die geringsten Beschädigungen auch an den feinsten Bildelementen (Tonwert 2%, 60 L/cm) überstand.

Beispiel 2

Es wurde wie in Beispiel 1 verfahren, nur wurde dieses Mal ein Oligomeres aus 60% Dicyclopentadien und 40% Maleinsäureanhydrid eingesetzt, welches ein mittleres Molekulargewicht von 670 und einen K-Wert von 9,6 besass. Mit diesem Aufzeichnungsmaterial wurde wie in Beispiel 1 eine Offsetdruckplatte hergestellt, die gleich gute Druckergebnisse lieferte; die Auswaschzeit bei ihrer Herstellung konnte jdoch um 40% verkürzt werden.

Beispiel 3

80 Teile eines Oligomeren aus 65% Dicyclopentadien und 35% Maleinsäureanhydrid (mittleres Molekulargewicht etwa 750) wurden in 500 Vol.-Teilen Diglykoldimethylether gelöst und anschliessend 10 Teile Ethylenglykol zugegeben.

Die Mischung wurde für 4 Stunden auf 140 °C erhitzt und nach dem Abkühlen die Lösung langsam in 3000 Vol.-Teile Wasser eingetropft, wobei ein bräunliches Polymer ausfiel, das nach dem Abtrennen und Trocknen einen Erweichungsbereich über 270 °C besass. Der Erweichungsbereich des Ausgangsoligomeren vor der Umsetzung mit Ethylenglykol lag bei etwa 230 °C.

Mit dem so erhaltenen Ethylenglykol-modifizierten Dicyclopentadien/Maleinsäureanhydrid-Copolymerisat wurde entsprechend Beispiel 1 eine Offsetdruckplatte hergestellt, die ausgezeichnete Eigenschaften aufwies.

Beispiel 4

100 Teile eines Oligomeren aus 60% Dicyclopentadien und 40% Maleinsäureanhydrid (mittleres Molekulargewicht 670), 2 Teile Hydrochinonmonomethylether und 45 Teile Pentaerythritdiacrylat wurden in 500 Teilen Diglykoldimethylether gelöst und 8 Stunden bei 90 °C gerührt. Danach wurde das erhaltene Polymer als braunes Pulver in Wasser ausgefällt.

55 Teile des so erhaltenen polymeren Umsetzungsproduktes des Dicyclopentadien/Maleinsäureanhydrid-Copolymerisates, 36 Teile Glykolamol, 3 Teile N-Vinylcaprolactam, 4 Teile Benzosuberon, 2,5 Teile Michlers Keton, 50 ppm Safranin T, 0,5 Teile Anethol, 0,2 Teile Hydrochinonmonomethylether und 0,7 Teile Viktoriareinblau wurden in 1000 Teile Ethylenglykol gelöst. Diese Lösung wurde nach Filtration auf eine elektrisch aufgerauhte, anodisch oxidierte und mit Nassdampf nachbehandelte Aluminiumplatte derart aufgetragen, dass ein Beschichtungsgewicht (Trockengewicht) von etwa 19 mg/dm² resultierte. Die photopolymerisierbare Schicht wurde nach dem Trocknen mit einer 2,5 µm dicken Schicht aus Polyvinylalkohol (88% verseift) überschichtet.

Das so erhaltene Aufzeichnungsmaterial wurde mit einer Gallium dotierten Quecksilberhochdrucklampe von 5 kW-Leistung in 1 m Abstand bildmässig belichtet. Als Bildvorlage wurde dabei ein Standardnegativ für die Offsetbelichtung (eingeführt von FOGRA) verwendet. Die Belichtungszeit betrug 8 Sekunden. Danach wurde mit einem handelsüblichen wässrig-alkalischen Entwicklerlösungsmittel, dessen pH-Wert durch Verdünnung mit Wasser auf 11,5 abgesenkt worden war, ausgewaschen. Die resultierende Druckform gab das Bildnegativ originalgetreu und exakt wieder. Es wurden 12 Sufenkeile reproduziert, wobei auch noch 4 µm-Linien negativ und positiv ausgebildet waren.

Von dieser so hergestellten Offsetdruckplatte wurden anschliessend 20 000 Drucke gemacht, ohne dass eine Verschleisserscheinung auf der Platte zu beobachten war.

## Patentansprüche

1. Photopolymerisierbares Aufzeichnungsmaterial zur Herstellung von Druckformen, insbesondere zur Herstellung von Flachdruckformen, mit einer auf einem dimensionsstabilen Träger aufgebrachten photopolymerisierbaren, wässrig-entwickelbaren Kopierschicht (S) einer Mischung von

(a) einem in wässrig-alkalischen Medien löslichen bzw. dispergierbaren polymeren Bindemittel,

(b) mindestens einer ethylenisch ungesättigten, photopolymerisierbaren niedermolekularen Verbindung,

(c) mindestens einem Photopolymerisationsinitiator,

(d) mindestens einem Farbstoff und/oder einem Pigment sowie

(e) gegebenenfalls weiteren Zusatz- und/oder Hilfsstoffen, dadurch gekennzeichnet, dass in der photopolymerisierbaren Kopierschicht (S) als Bindemittel (a) mindestens ein oligomeres, in wässrig-alkalischen Medien lösliches oder dispergierbares Copolymerisat mit einem mittleren Molekulargewicht im Bereich von etwa 500 bis 1000 auf der Basis von cyclischen Dienen und/oder ein durch Umsetzung derartiger oligomerer Copolymerisate mit einer unterstöchiometrischen Menge an mehrfunktionellen Verbindungen, die mit den Anhydrid- oder freien Carboxylgruppen der oligomeren Copolymerisate zu reagieren vermögen, erhaltenes höhermolekulares, in wässrig-alkalischen Medien lösliches oder dispergierbares Copolymerisat enthalten ist.

2. Photopolymerisierbares Aufzeichnungsmaterial gemäss Anspruch 1, dadurch gekennzeichnet, dass es sich bei den cyclischen Dienen um Monomere des Cyclopentadien-Typs, insbesondere Dicyclopentadien, handelt.

3. Photopolymerisierbares Aufzeichnungsmaterial gemäss einem der Ansprüche 1 oder 2, dadurch gekennzeichnet, dass es als Bindemittel (a) ein Copolymerisat auf Basis von Dicyclopentadien, Maleinsäureanhydrid und/oder Maleinsäurehalbester enthält.

4. Verfahren zur Herstellung von Druckformen, insbesondere Flachdruckformen, bei dem ein photopolymerisierbares Aufzeichnungsmaterial mit einer auf einem dimensionsstabilen Träger aufgebrachten photopolymerisierbaren Kopierschicht (S) bildmässig mit aktinischem Licht belichtet und anschliessend mit einem wässrig-alkalischen Entwicklerlösungsmittel ausgewaschen wird, dadurch gekennzeichnet dass ein Aufzeichnungsmaterial gemäss einem der Ansprüche 1 bis 3 eingesetzt wird.

5. Verfahren nach Anspruch 4, dadurch gekennzeichnet, dass die Druckform, gegebenenfalls nach einem Trocknungsschritt, durch Belichten mit aktinischem Licht und/oder Erhitzen nachgehärtet und nachvernetzt wird.

## Revendications

Matériau d'enregistrement photopolymérisable pour la fabrication de formes d'impression, en particulier de formes d'impression offset, comportant une couche réserve (S) développable à l'eau, photopolymérisable, appliquée sur un support stable en dimension et constituée par un mélange de

a) un liant polymère dispersable ou soluble dans des milieux alcalins aqueux,

b) au moins un composé à bas poids moléculaire, photopolymérisable, insaturé éthyléniquement,

c) au moins un initiateur de photopolymérisation,

d) au moins une matière colorante et/ou un pigment, ainsi que,

e) éventuellement d'autres additifs et/ou auxiliaires, caractérisé par le fait que, dans la couche réserve (S) photopolymérisable, est contenu, comme liant (a), au moins un copolymérisat oligomère, soluble ou dispersable dans les milieux aqueux-alcalins, et à poids moléculaire moyen compris entre environ 500 et 1000 à base de diènes cycliques et/ou un copolymérisat à poids moléculaire élevé, soluble ou dispersable dans les milieux aqueux-alcalins, obtenu par réaction de copolymérisats oligomères de ce type avec une quantité hypostœchiométrique de composés plurifonctionnels qui permettent de réagir avec les groupes anhydride ou carboxyle libres du copolymérisat oligomère.

2. Matériau d'enregistrement photopolymérisable selon la revendication 1, caractérisé par le fait qu'il s'agit, pour les diènes cycliques de monomères, du type cyclopentadiène, en particulier dicyclopentadiène.

3. Matériau d'enregistrement photopolymérisable selon l'une des revendications 1 ou 2, caractérisé par le fait que, comme liant (a), il contient un copolymérisat à base du dicyclopentadiène, anhydride maléique et/ou semiester maléique.

4. Procédé de fabrication de formes d'impression, en particulier formes d'impression offset dans lequel on expose à la lumière actinique, selon une image, un matériau d'enregistrement photopolymérisable, à couche réserve (S) photopolymérisable, appliquée sur un support stable en dimension, puis on lave avec un révélateur alcalin-aqueux, caractérisé par le fait que l'on emploi un matériau d'enregistrement selon l'une des revendications 1 à 3.

5. Procédé selon la revendication 4, caractérisé par le fait que la forme d'impression, éventuellement après une phase de séchage, est ensuite soumise à un durcissement et une réticulation complémentaires par exposition à la lumière actinique et/ou réchauffage.

## Claims

1. A photopolymerizable recording material for the production of printing plates, in particular lithographic printing plates, possessing a photopolymerizable copying layer (L) which is applied to a dimensionally stable base, can be developed with an aqueous medium and consists of a mixture of

(a) a polymeric binder which is soluble or dispersible in aqueous alkaline media,

(b) one or more ethylenically unsaturated photopolymerizable low molecular weight compounds,

(c) one or more photopolymerization initiators, and

(d) one or more dyes and/or pigments, with or without

(e) further additives and/or assistants, characterized in that the photopolymerizable copying layer (L) contains, as binder (a), one or more oligomeric copolymers which are soluble or dispersible in aqueous alkaline media, have a mean molecular weight of from about 500 to 1000, and are based on cyclic dienes and/or a relatively high molecular weight copolymer which is soluble or dispersible in aqueous alkaline media, and has been obtained by reacting such oligomeric copolymers with a less than stoichiometric amount of polyfunctional compounds capable of reacting with the anhydride groups or free carboxyl groups of the oligomeric copolymers.

2. A photopolymerizable recording material as claimed in claim 1, characterized in that the cyclic dienes are monomers of the cyclopentadiene type, especially dicyclopentadiene.

3. A photopolymerizable recording material as claimed in claim 1 or 2, characterized in that it contains, as binder (a), a copolymer based on dicyclopentadiene, maleic anhydride and/or half esters of maleic acid.

4. A process for the production of a printing plate, in particular a lithographic printing plate, in which a photopolymerizable recording material possessing a photopolymerizable copying layer (L) applied to a dimensionally stable base is exposed imagewise to actinic light and then washed out with an aqueous alkaline developer, characterized in that a recording material as claimed in any of claims 1 to 3 is used.

5. A process as claimed in claim 4, characterized in that the printing plate, after an optional drying step, is post-cured and post-crosslinked by exposure to actinic light and/or by heating.